(19) Europäisches Patentamt
European Patent Office
Office européen des brevets

(11) Veröffentlichungsnummer : **0 440 057 B1**

(12) # EUROPÄISCHE PATENTSCHRIFT

(45) Veröffentlichungstag der Patentschrift :
**27.09.95 Patentblatt 95/39**

(51) Int. Cl.[6] : **G03F 7/023,** G03F 7/039

(21) Anmeldenummer : **91100672.4**

(22) Anmeldetag : **21.01.91**

(54) **Strahlungsempfindliches Gemisch und hieraus hergestelltes strahlungsempfindliches Aufzeichnungsmaterial.**

(30) Priorität : **27.01.90 DE 4002397**

(43) Veröffentlichungstag der Anmeldung :
**07.08.91 Patentblatt 91/32**

(45) Bekanntmachung des Hinweises auf die Patenterteilung :
**27.09.95 Patentblatt 95/39**

(84) Benannte Vertragsstaaten :
**DE FR GB**

(56) Entgegenhaltungen :
**EP-A- 0 212 439**
**EP-A- 0 212 440**
**EP-A- 0 323 854**
**DE-A- 3 831 782**

(73) Patentinhaber : **HOECHST AKTIENGESELLSCHAFT**
**D-65926 Frankfurt am Main (DE)**

(72) Erfinder : **Elsässer, Andreas, Dr. Dipl.-Chem.**
**Hertastrasse 1b**
**W-6270 Idstein (DE)**
Erfinder : **Mohr, Dieter, Dr. Dipl.-Chem.**
**Eaubonner Strasse 8**
**W-6501 Budenheim (DE)**

**EP 0 440 057 B1**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Strahlungsempfindliches Gemisch und hieraus hergestelltes strahlungsempfindlixhes Aufzeichnungsmaterial

Die Erfindung betrifft ein positiv arbeitendes strahlungs-bzw. lichtempfindliches Gemisch, das als wesentliche Bestandteile ein in Wasser unlösliches, in wäßrig-alkalischen Lösungen lösliches polymeres Bindemittel und ein 1,2-Chinondiazid und/oder eine Kombination aus einer unter Einwirkung von aktinischer Strahlung starke Säure bildenden Verbindung und einer Verbindung mit mindestens einer spaltbaren C-O-C-Bindung enthält. Die Erfindung betrifft auch ein strahlungsempfindliches Aufzeichnungsmaterial aus einem Schichtträger und dem darauf aufgebrachten strahlungsempfindlichen Gemisch.

Positiv arbeitende lichtempfindliche Gemische, d. h. Gemische aus den genannten Bestandteilen, deren Kopierschicht an den belichteten Stellen löslich wird, sind bekannt und für vielfältige Anwendungsmöglichkeiten, wie zur Herstellung von Flachdruckplatten oder Photoresists beschrieben.

Ein wesentlicher Teil der Eigenschaften dieser Kopierschichten wird vom mengenmäßigen Hauptbestandteil des strahlungsempfindlichen Gemisches, dem polymeren Bindemittel, bestimmt. Als Bindemittel für Positiv-Kopierschichten werden praktisch ausschließlich Phenol- oder Kresol-Formaldehyd-Kondensationsprodukte vom Novolaktyp eingesetzt. Für einige Anwendungen von Positiv-Kopierschichten sind jedoch die daraus resultierenden Eigenschaften noch nicht optimal, was insbesondere die Wärmestandfestigkeit im Falle von Photoresistanwendungen und die Höhe der Druckauflagen bei der Verwendung als Flachdruckplatten betrifft.

Es hat sich gezeigt, daß durch Substitution der Novolake durch Bindemittel mit höherer Glasübergangstemperatur ein generell besseres Eigenschaftsprofil resultiert. So sind eine ganze Reihe von alkalilöslichen Bindemitteln für Positiv-Kopierschichten beschrieben, wie etwa Phenolharze auf Naphtholbasis (US-PS 4 551 409), Homo- und Copolymerisate von Vinylphenolen (DE-A- 23 22 230 entsprechend US-PS 3 869 292 und DE-A- 34 06 927 entsprechend US-PS 4 678 737), Polymerisate der Ester von Acrylsäuren mit Phenolen (JP-OS 76/36 129, EP-A 0 212 440 und EP-A-0 212 439) oder Copolymerisate von Hydroxyphenylmaleinsäureimiden (EP-A-0 187 517).

Bindemittel der genannten Art konnten aber bislang keine praktische Anwendung finden. Ein Grund hierfür ist, daß diese Polymerisate eine wesentliche Forderung , die an Bindemittel von Positiv-Kopierschichten gestellt wird, nicht befriedigend erfüllen, nämlich die der Möglichkeit zur thermischen Selbstvernetzung. Diese Eigenschaft, die bei Novolaken gegeben ist, ist dann von Bedeutung, wenn die Kopierschicht aggressiven Chemikalien standhalten soll. In dieser Hinsicht ist auch bekannt, in die Polymerisate Einheiten einzubauen, die zwar nicht alkalilöslich sind, aber die thermische Vernetzung ermöglichen (EP-A-0 184 044). Hierdurch werden jedoch andere Eigenschaften, wie etwa das Entwicklungsverhalten und die Lagerstabilität des Gemisches, beeinträchtigt.

In der DE-A- 38 20 699 werden Polymerisate auf Basis von Hydroxybenzylacrylamiden beschrieben, die der Forderung nach vernetzbaren, alkalilöslichen Monomerbausteinen entsprechen. Von Nachteil ist jedoch, daß diese Monomeren lediglich in begrenzter Menge in den Polymerisaten enthalten sein können, da andernfalls Lichtempfindlichkeit und Entwicklungsverhalten ungünstig beeinflußt werden.

Es war daher Aufgabe der Erfindung, ein positiv arbeitendes strahlungsempfindliches Gemisch zu schaffen, mit dem Flachdruckplatten mit höherer Druckauflagenleistung bzw. Photoresists mit verbessertem Wärmestand bereitgestellt werden können, und das ohne Beeinträchtigung seiner Lichtempfindlichkeit und seines Entwicklungsverhaltens thermisch vernetzbar ist.

Die Lösung dieser Aufgabe geht von einem strahlungsempfindlichen Gemisch der eingangs genannten Art aus und sie ist dadurch gekennzeichnet, daß das Gemisch als Bindemittel ein Polymerisat mit Einheiten der allgemeinen Formel I

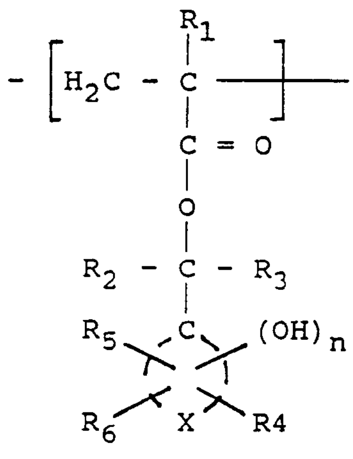

I

enthält, worin

$R_1$ ein Wasserstoff- oder Halogenatom, eine Cyanid- oder eine Alkylgruppe,

$R_2$, $R_3$ gleich oder verschieden sind und Wasserstoff, Alkyl- oder Arylgruppen,

$R_4$, $R_5$ und $R_5$ gleich oder verschieden sind und Wasserstoff-oder Halogenatome, Alkyl-, Alkoxy- oder Arylgruppen,

X die zur Vervollständigung eines ein- oder mehrkernigen carbocyclischen aromatischen Ringsytems erforderlichen Atome und

n 1, 2 oder 3

bedeuten.

In bevorzugter Ausführung enthält das Gemisch als Bindemittel ein Polymeres mit Einheiten der allgemeinen Formel I, worin

$R_1$ ein Wasserstoff- oder Halogenatom, eine Cyanid- oder eine $C_1$ - $C_6$ Alkylgruppe,

$R_2$, $R_3$ gleich oder verschieden sind und Wasserstoff oder $C_1$ - $C_4$ Alkylgruppen,

$R_4$, $R_5$ und $R_5$ gleich oder verschieden sind und Wasserstoff, $C_1$ - $C_4$ Alkylgruppen oder Halogen,

X die zur Vervollständigung eines Benzol- oder Napthalinrings erforderlichen Kohlenstoffatome und

n 1

bedeuten.

Besonders vorteilhaft ist ein Gemisch, bei dem

$R_1$ Wasserstoff oder die Methylgruppe,

$R_2$, $R_3$ und $R_4$ Wasserstoff,

$R_5$ Wasserstoff, eine $C_1$ - $C_4$ Alkylgruppe oder Halogen,

$R_6$ Wasserstoff, eine $C_1$ - $C_4$ Alkylgruppe, eine Arylgruppe oder Halogen,

X die zur Vervollständigung eines Benzol- oder Napthalinrings erforderlichen Kohlenstoffatome und

n 1

bedeuten.

Im Falle, daß $R_1$ eine Alkylgruppe ist, enthält diese im allgemeinen 1 bis 6, vorzugsweise 1 oder 2 Kohlenstoffatome. Besonders bevorzugt werden Verbindungen, in denen $R_1$ ein Wasserstoffatom oder die Methylgruppe bedeutet.

Von den Substituenten $R_2$, $R_3$ ist vorteilhaft mindestens einer Wasserstoff. Vorzugsweise sind beide Wasserstoff. Wenn diese Symbole Alkylgruppen bedeuten, haben diese in der Regel 1 bis 6, insbesondere 1 bis 3 Kohlenstoffatome.

Von den Substituenten $R_4$, $R_5$ und $R_6$ ist $R_4$ bevorzugt Wasserstoff, $R_5$ vorteilhaft eine Alkylgruppe mit 1 - 4 Kohlenstoffatomen, vorzugsweise eine Methylgruppe und $R_5$ eine Alkylgruppe mit 1 - 4 Kohlenstoffatomen oder eine Arylgruppe.

Allgemein sind hier unter Alkylgruppen verzweigte und unverzweigte, gesättigte und ungesättigte Gruppen mit cyclischen und offenen Ketten zu verstehen, die durch Halogenatome oder Hydroxylgruppen substituiert sein oder Ether- oder Ketongruppen enthalten können. Bevorzugt sind unverzweigte Alkylgruppen mit 1 bis 4 Kohlenstoffatomen. Unter Arylgruppen sind hetero- oder carbocyclische aromatische Ringsysteme zu

verstehen, die ein- oder mehrkernig, durch Aryl-, Alkoxy-, Hydroxygruppen oder Halogenatome susbtituiert sein können.

Die Position der beschriebenen Substituenten am Ringsystem X unterliegt keinerlei Beschränkungen, sie richtet sich lediglich nach der präparativen Zugänglichkeit der Verbindungen.

Das carbocyclische aromatische Ringsystem X kann ein- oder mehrkernig sein. Unter den carbocyclischen Ringsystemen sind insbesondere Benzol- und Naphthalin-Systeme zu nennen.

Als Halogenatome kommen insbesondere Chlor-, Brom- und Jodatome, vorzugsweise Chloratome infrage.

Bevorzugte Beispiele für erfindungsgemäß eingesetzte Einheiten sind in den folgenden Formelbildern wiedergegeben

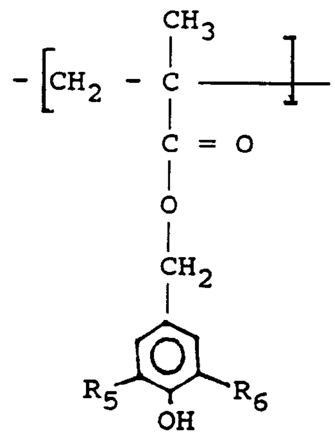

II

worin

$R_5$ und $R_6$ gleich oder verschieden sind und Wasserstoff, $C_1$ - $C_4$ Alkyl oder Halogen bedeuten

oder

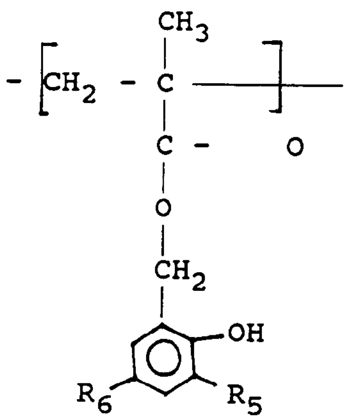

III

worin

$R_5$ $C_1$ - $C_4$ Alkyl oder Halogen und

$R_6$ $C_1$ - $C_4$ Alkyl, Halogen oder ein gegebenenfalls durch Alkyl, Alkoxy, oder Halogen substituiertes Aryl bedeuten.

Die Darstellung der Monomeren mit Einheiten der Formel I erfolgt im allgemeinen durch Umsetzung von Hydroxymethylsubstituierten Aromaten mit Acryl- oder Methacrylsäure oder durch Abspaltung von Natriumhalogenid zwischen Halogenmethyl-substituierten Aromaten und Natriumacrylat oder -methacrylat.

Diese Verfahren und Synthesebeispiele sind in US-A 3 116 305, DE-A 21 63 453 sowie JP-A 58/170 731 beschrieben.

Die Homopolymerisation der Monomeren mit Einheiten der Formel I oder deren Copolymerisation mit anderen Monomeren läßt sich nach konventionellen Methoden durchführen, beispielsweise in Gegenwart eines Polymerisationsinitiators wie Azo-bis-isobuttersäurenitril in organischen Lösungsmitteln wie Methylethylketon oder Ethanol bei erhöhten Temperaturen während eines Zeitraums von 1 bis 20 Stunden. Daneben ist aber

auch eine Suspensions-, Emulsions- oder Massepolymerisation möglich, die auch durch Strahlung, Hitze oder ionische Initiatoren ausgelöst werden kann.

Die Polymerisate mit Einheiten der Formel I können Homopolymerisate, welche ausschließlich Struktureinheiten der Formel I enthalten, oder Mischpolymerisate aus Monomeren entsprechend der Formel I und einem oder mehreren anderen Vinylmonomeren, wie Styrol, Acryl- oder Methacrylsäurealkyl-oder -arylester, gegebenenfalls auch mit phenolischen Gruppen, sein.

Weiterhin können verschiedene phenolhaltige Monomere der allgemeinen Formel I miteinander copolymerisiert werden, gegebenenfalls mit weiteren Vinylmonomeren.

Das Molekulargewicht der Homo- bzw. Copolymerisate kann in weiten Grenzen schwanken; bevorzugt werden Polymerisate mit $M_w$ = 1000 - 200.000, besonders solche mit $M_w$ = 5000 - 100.000 verwendet. Die Hydroxylzahl liegt im allgemeinen im Bereich von 100 bis etwa 450, vorzugsweise zwischen 200 und 350.

Die Auswahl von geeigneten Homo- oder Copolymerisaten richtet sich im Einzelfall nach der Anwendung und nach der Art der übrigen Komponenten in der Kopierschicht.

Geeignete Comonomer-Einheiten werden durch die allgemeine Formel IV

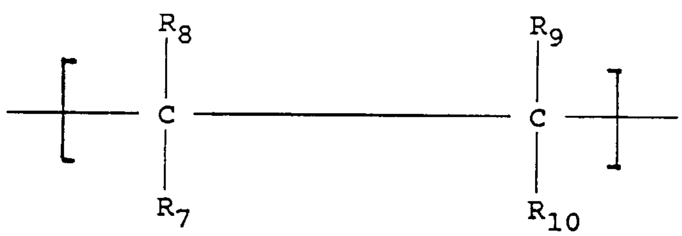

IV

wiedergegeben, worin

$R_7$ Wasserstoff,

$R_8$ Wasserstoff oder eine Carboxylgruppe, die mit $R_9$, wenn letzteres eine Carboxylgruppe ist, zu einem Säureanhydrid oder einem gegebenenfalls durch Alkyl substituierten Imid verbunden sein kann,

$R_9$ eine Alkyl-, Alkoxy-, Alkoxycarbonyl-, Acyl-, Acyloxy-, Aryl-, Aryloxycarbonyl-, Formyl-, Cyanid-, Carboxyl-, Hydroxyl-oder Aminocarbonylgruppe und

$R_{10}$ Wasserstoff, Halogen oder eine Alkylgruppe

bedeuten. Bevorzugt werden Einheiten eingesetzt, in denen

$R_7$ und $R_8$ Wasserstoff,

$R_9$ eine $C_1$ - $C_4$ Alkylgruppe, eine $C_1$ - $C_8$ Alkoxygruppe, eine Alkoxycarbonylgruppe mit 2 - 13 Kohlenstoffatomen, eine Acyloxygruppe mit 2 - 18 Kohlenstoffatomen, eine Arylgruppe mit 6 - 10 Kohlenstoffatomen oder eine Aryloxycarbonylgruppe mit 7 - 11 Kohlenstoffatomen, wobei die Arylgruppen durch Hydroxylgruppen substituiert sein können, und

$R_{10}$ Wasserstoff oder die Methylgruppe

bedeuten.

Wenn $R_9$ und $R_{10}$ Alkylgruppen sind, haben diese im allgemeinen 1 - 4 Kohlenstoffatome. Als Vertreter für $R_9$ kommen in Betracht: Alkoxygruppen mit 1 - 8 Kohlenstoffatomen, Alkoxycarbonylgruppen mit 2 - 13 Kohlenstoffatomen, Acyloxygruppen mit 2 - 18 Kohlenstoffatomen und Arylgruppen mit 6 - 10 Kohlenstoffatomen. Die Aminocarbonylgruppen können mit 1 - 8 Kohlenstoffatomen substituiert sein.

Beispiele hierfür sind Styrol, α-Chlorstyrol, α-Methylstyrol, 2-, 3- oder 4-Chlormethylstyrol, 4-Bromstyrol, Methylvinylether, Ethylvinylether, Propylvinylether, Butylvinylether, Acrylnitril, Acrolein, Butadien, Acrylsäure, Methacrylsäure, die Methyl-, Ethyl-, Propyl-, Butyl-, Pentyl-, Hexyl-, Octyl-, Decyl-, Dodecyl-, 2-Ethylhexyl-, Phenyl-, Benzyl-, Biphenyl- oder Naphthylester dieser Säuren, Methacrylamid, Acrylamid, Vinylacetat, Vinylisobutylketon und Maleinsäureanhydrid. Comonomere mit phenolischen Hydroxylgruppen haben bevorzugt die folgenden Strukturen:

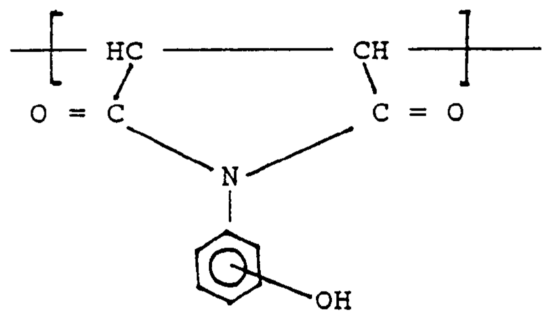

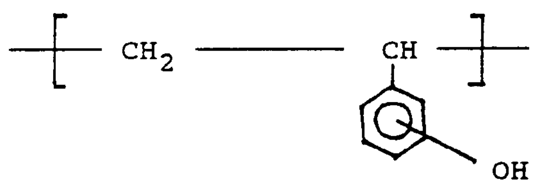

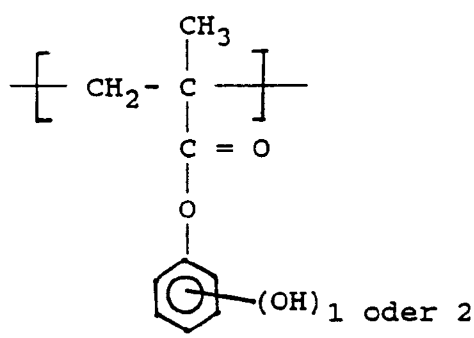

Der Gehalt an Einheiten der Formel I im Copolymerisat richtet sich nach den übrigen Komponenten des Gemisches und nach der Anwendung. Im allgemeinen werden im erfindungsgemäßen Gemisch Polymerisate mit einem Gehalt von 10 bis 100, vorzugsweise 15 bis 80 Molprozent an gegebenenfalls verschiedenen Einheiten der Formel I eingesetzt.

Zur Herstellung der erfindungsgemäßen Gemische wird das polymere Bindemittel kombiniert mit lichtempfindlichen Verbindungen bzw. Gemischen, deren Löslichkeit in einer wäßrig-alkalischen Entwicklerlösung mit dem Belichten erhöht wird. Hierzu gehören 1,2-Chinondiazide und Kombinationen von photolytischen Säurespendern mit säurespaltbaren Verbindungen.

Das polymere Bindemittel ist in diesen strahlungsempfindlichen Gemischen im allgemeinen Bereich von 10 bis 95 Gewichtsprozent, bevorzugt von 50 bis 90 Gewichtsprozent, bezogen auf die nichtflüchtigen Anteile, vorhanden.

Als 1,2-Chinondiazide werden bevorzugt 1,2-Naphthochinondiazid-(2)-4-oder -5-sulfonsäureester oder -amide verwendet. Von diesen werden die Ester, insbesondere die der 5-Sulfonsäuren, bevorzugt. Geeignete Verbindungen dieser Art sind bekannt und beispielsweise in der DE-AS 938 233, entsprechend GB-PS 739,654 beschrieben.

Die Menge von o-Chinondiazidverbindungen beträgt im allgemeinen 3 bis 50, bevorzugt 7 bis 35 Gewichtsprozent, bezogen auf die nichtflüchtigen Anteile des Gemisches.

Es ist auch möglich, die 1,2-Chinondiazidverbindungen in Form ihrer Ester mit den erfindungsgemäßen Polymeren einzusetzen. Die Veresterung der entsprechenden 1,2-Chinondiazidsäurechloride mit den Hydroxylgruppen der zugrunde liegenden Polymerisate erfolgt nach den in der Literatur bekannten Verfahren (DE-AS 25 07 548, ensprechend US-PS 4 139 384).

Auch Materialien auf Basis säurespaltbarer Verbindungen lassen sich mit gutem Effekt in dem erfindungsgemäßen Gemisch allein oder im Gemisch mit obigen 1,2-Chinondiaziden einsetzen.

Als durch Säure spaltbare Verbindungen sind in erster Linie zu nennen:

a) solche mit mindestens einer Orthocarbonsäureester- und bzw. oder Carbonsäureamidacetalgruppierung, wobei die Verbindungen auch polymeren Charakter haben und die genannten Gruppierungen als verknüpfende Elemente in der Hauptkette oder als seitenständige Substituenten auftreten können,

b) Oligomer- oder Polymerverbindungen mit wiederkehrenden Acetal-und/oder Ketalgruppierungen in der Hauptkette und

c) Verbindungen mit mindestens einer Enolether- oder N-Acylaminocarbonatgruppierung.

Durch Säure spaltbare Verbindungen des Typs a) als Komponenten strahlungsempfindlicher Gemische sind in der EP-A 0 022 571, entsprechend US-A 4 311 782, ausführlich beschrieben; Gemische, die Verbindungen des Typs b) enthalten, sind in der DE-C 23 06 248, entsprechend US-A 3 779 778, und in den DE-C 27 18 254 und US-A 4 189 323 beschrieben; Verbindungen des Typs c) werden in EP-A 0 006 627, entsprechend US-A 4 248 957 beschrieben.

Die säurespaltbaren Verbindungen können im strahlungsempfindlichen Gemisch im Bereich zwischen 5 und 70, vorzugsweise 5 und 40 Gewichtsprozent, bezogen auf die nichtflüchtigen Anteile vorhanden sein.

Als strahlungsempfindliche Komponenten, die beim Belichten starke Säuren bilden, sind eine große Anzahl von bekannten Verbindungen und Mischungen, wie Phosphonium-, Sulfonium- und Jodoniumsalze, Halogenverbindungen und Organometall-Organohalogen-Kombinationen geeignet.

Die genannten Phosphonium-, Sulfonium- und Jodoniumverbindungen werden in der Regel eingesetzt in Form ihrer in organischen Lösemitteln löslichen Salze, meist als Abscheidungsprodukt mit komplexen Säuren wie Borfluorwasserstoffsäure, Hexafluorphosphor-, Hexafluorantimon- und -arsensäure.

Grundsätzlich sind als halogenhaltige strahlungsempfindliche und Halogenwasserstoffsäure bildende Verbindungen alle auch als photochemische Radikalstarter bekannten organischen Halogenverbindungen, beispielsweise solche mit mindestens einem Halogenatom an einem Kohlenstoffatom oder an einem aromatischen Ring brauchbar (US-A 3 515 552). Von diesen Verbindungen werden die s-Triazin derivate mit 2 Halogenmethylgruppen, insbesondere Trichlormethylgruppen und einem aromatischen bzw. ungesättigten Substituenten im Triazinkern, wie sie in DE-C 27 18 259, entsprechend US-A 4 189 323, beschrieben sind, bevorzugt. Ebenso geeignet sind 2-Trichlormethyl-1,3,4-oxdiazole. Die Wirkung dieser halogenhaltigen Verbindungen kann auch durch bekannte Sensibilisatoren spektral beeinflußt und gesteigert werden.

Beispiele für geeignete photochemische Säurespender sind:

4-Methyl-6-trichlormethyl-2-pyron,4-(3,4,5-Trimethoxy-styryl)-6-trichlormethyl-2-pyron, 4-(4-Methoxystyryl)-6-(3,3,3-trichlorpropenyl)-2-pyron, 2-Trichlormethyl-benzimidazol, 2-Tribrommethylchinolin, 2,4-Dimethyl-1-tribromacetyl-benzol, 3-Nitro-1-tribromacetyl-benzol, 4-Dibromacetyl-benzoesäure, 1,4-Bis-dibrommethylbenzol, Tris-dibrommethyl-s-triazin, 2-(6-Methoxy-naphth-2-yl)-, 2-(Naphth-1-yl)-, 2-(4-Ethoxyethylnaphth-1-yl)-, 2-(Benzo-pyran-3-yl)-, 2-(4-Methoxyanthrac-1-yl)-, 2-(4-Styrylphenyl)-, 2-(Phenanthr-9-yl)-4,6-bis-trichlormethyl-s-triazin und die in den Beispielen aufgeführten Verbindungen.

Die Menge des photochemischen Säurespenders kann, je nach seiner chemischen Natur und der Zusammensetzung der Schicht, ebenfalls sehr verschieden sein. Günstige Ergebnisse werden erhalten mit etwa 0,5 bis zu 20 Gewichtsprozent, bezogen auf den Gesamtfeststoff. Bevorzugt sind 0,1 bis 12 Gewichtsprozent. Besonders für lichtempfindliche Schichten von Dicken über 0,01 mm empfiehlt es sich, relativ wenig Säurespender zu verwenden.

Zusätzlich können noch zahlreiche andere Oligomere und Polymerisate mitverwendet werden, z.B. Phenolharze vom Novolaktyp oder Vinylpolymerisate wie Polyvinylacetale, Polymethacrylate, Polyacrylate, Polyvinylether und Polyvinylpyrrolidone, die selbst durch Comonomere modifiziert sein können.

Der günstigste Anteil an diesen Zusätzen richtet sich nach den anwendungstechnischen Erfordernissen und dem Einfluß auf die Entwicklungsbedingungen und beträgt im allgemeinen nicht mehr als 20 Gewichtsprozent vom erfindungsgemäß eingesetzten Polymerisat. In geringen Mengen kann die strahlungsempfindliche Schicht für spezielle Erfordernisse wie Flexibilität, Haftung, Glanz etc. außerdem noch Substanzen wie Polyglykole, Celluloseether, z.B. Ethylcellulose, Netzmittel und feinteilige Pigmente enthalten.

Ferner können dem strahlungsempfindlichen Gemisch noch lösliche oder auch feinteilige dispergierbare Farbstoffe sowie, je nach Anwendungszweck, auch UV-Absorber zugesetzt werden. Als Farbstoffe haben sich die Triphenylmethanfarbstoffe, etwa in der Form ihrer Carbinolbasen, besonders bewährt. Die günstigsten Mengenverhältnisse der Komponenten lassen sich im Einzelfall durch Vorversuche leicht ermitteln.

Die Erfindung betrifft auch ein strahlungsempfindliches Aufzeichnungsmaterial aus einem Schichtträger und einer strahlungsempfindlichen Schicht, die ein Gemisch nach den Ansprüchen enthält.

Zur Beschichtung eines geeigneten Schichtträgers werden die Gemische im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemäße Gemisch sind Ketone, wie Methylethylketon, chlorierte Kohlenwasserstoffe, wie Trichlorethylen und 1,1,1-Trichlorethan, Alkohole, wie n-Propanol, Ether, wie Tetrahydrofuran, Alkoholether, wie Ethylenglykol-monoethylether, Propylenglykolmonomethylether und Ester, wie Butylacetat oder Alkylenglykolmonoalkyletheracetate.

Es können auch Gemische verwendet werden, die zudem noch für spezielle Zwecke Lösungsmittel, wie Acetonitril, Dioxan oder Dimethylformamid enthalten können. Prinzipiell sind alle Lösungsmittel verwendbar, die mit den Schichtkomponenten nicht irreversibel reagieren. Partialether von Glykolen, insbesondere Ethylenglykolmonomethylether und Propylenglykolmonomethylether allein oder im Gemisch werden besonders bevorzugt.

Als Schichtträger für Schichtdicken unter ca. 10 µm werden meist Metalle verwendet. Für Offsetdruckplatten können eingesetzt werden: walzblankes, mechanisch und/oder elektrochemisch aufgerauhtes und gegebenenfalls anodisiertes Aluminium, das zudem noch chemisch, z.B. mit Polyvinylphosphonsäure, Silikaten,Phosphaten,Hexafluorzirkonaten oder mit hydrolysiertem Tetraethylorthosilikat vorbehandelt sein kann.

Die Beschichtung des Schichtträgers erfolgt in bekannter Weise durch Aufschleudern, Sprühen, Tauchen, Walzen, mittels Breitschlitzdüsen, Rakeln oder durch Gießer-Antrag.

Zum Belichten können die üblichen Lichtquellen wie Röhrenlampen, Xenonimpulslampen, metallhalogeniddotierte Quecksilberdampf-Hochdrucklampen und Kohlebogenlampen verwendet werden.

Unter Belichtung bzw. Bestrahlung ist in dieser Beschreibung die Einwirkung aktinischer elektromagnetischer Strahlung in Wellenlängenbereichen unterhalb etwa 500 nm zu verstehen. Alle in diesem Wellenlängenbereich emittierenden Strahlungsquellen sind prinzipiell geeignet.

Mit Vorteil können auch Laserbestrahlungsgeräte, insbesondere automatische Verarbeitungsanlagen verwendet werden, die als Strahlungsquelle beispielsweise einen Argon- oder Krypton-Ionen-Laser enthalten.

Die Bestrahlung kann auch mit Elektronenstrahlen erfolgen. In diesem Falle können auch im üblichen Sinne nicht lichtempfindliche Säure bildende Verbindungen als Initiatoren der Solubilisierungsreaktion eingesetzt werden, z.B. halogenierte aromatische Verbindungen oder halogenierte polymere Kohlenwasserstoffe. Auch Röntgenstrahlen können zur Bilderzeugung verwendet werden.

Die bildmäßig belichtete oder bestrahlte Schicht kann in bekannter Weise mit praktisch den gleichen Entwicklern, wie sie für handelsübliche Naphthochinondiazid-Schichten und Kopierlacke bekannt sind, entfernt werden, oder die neuen Materialien können in ihrem Kopierverhalten mit Vorteil auf die bekannten Hilfsmittel wie Entwickler und programmierte Sprühentwicklungsgeräte abgestimmt werden. Die wäßrigen Entwicklerlösungen können zum Beispiel Alkaliphosphate, -silikate oder -hydroxide und ferner Netzmittel sowie gegebenenfalls kleinere Anteile organischer Lösungsmittel enthalten. In bestimmten Fällen sind auch Lösungsmittel-Wasser-Gemische als Entwickler brauchbar. Die Wahl des günstigsten Entwicklers kann durch Versuche mit der jeweils verwendeten Schicht ermittelt werden. Bei Bedarf kann die Entwicklung mechanisch unterstützt werden.

Bei der Anwendung als Druckplatten können zur Erhöhung der Widerstandsfähigkeit beim Druck sowie der Resistenz gegen Auswaschmittel, Korrekturmittel und durch UV-Licht härtbare Druckfarben die entwickelten Platten kurzzeitig auf erhöhte Temperaturen erwärmt werden, wie es für Diazoschichten aus der GB-PS 1 154 749 bekannt ist.

Durch die Erfindung wird erreicht, daß man nunmehr strahlungsempfindliche Gemische und Aufzeichnungsmaterialien zur Verfügung stellen kann, die eine gute Lagerfähigkeit, gute Lichtempfindlichkeit und einwandfreies Entwicklungsverhalten besitzen, von denen in hoher Auflage gedruckt werden kann, die bei der Verwendung als Photoresist einen hervorragenden Wärmestand aufweisen, die thermisch nachgehärtet werden können und nach der Nachhärtung gegenüber den bekannten Materialien eine gute Chemikalienbeständigkeit haben.

Im folgenden werden Beispiele für bevorzugte Ausführungsformen angegeben. In den Beispielen stehen Gewichtsteile (Gt) und Volumenteile (Vt) im Verhältnis von g zu ccm. Prozent- und Mengenverhältnisse sind, wenn nichts anderes angegeben ist, in Gewichtseinheiten zu verstehen.

Allgemeine Vorschriften zur Herstellung der Polymerisate

| | |
|---|---|
| 1 mol | des Monomeren oder Monomergemisches (vgl. Tabelle 1) und |
| 0,015 mol | Azo-bis-isobuttersäurenitril |

werden in Tetrahydrofuran zu einer Ansatzlösung mit einem Feststoffgehalt von 40 % vereint und 17 Stunden bei 70 °C unter Stickstoff-Inertisierung polymerisiert. Dann wird unter starkem Rühren in das 25-fache Volumen Wasser eingetragen. Das ausgefallene Polymerisat wird bei 50 °C 48 Stunden im Vakuum getrocknet. In Tabelle 2 sind die auf diesem Wege hergestellten Polymerisate zusammengefaßt.

**Tabelle 1:**

Monomere

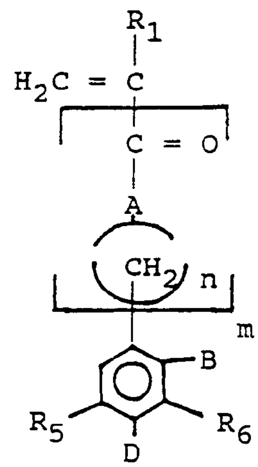

**Tabelle 1:**

| Monomer Nr. | $R_1$ | A | n | m | $R_5$ | $R_6$ | B | D | Bemerkungen |
|---|---|---|---|---|---|---|---|---|---|
| 1 | $CH_3$ | O | 1 | 1 | $CH_3$ | $CH_3$ | OH | H | erfindungsgemäß |
| 2 | $CH_3$ | O | 1 | 1 | $CH_3$ | $CH_3$ | H | OH | erfindungsgemäß |
| 3 | H | O | 1 | 1 | $CH_3$ | $CH_3$ | H | OH | erfindungsgemäß |
| 4 | $CH_3$ | O | 1 | 1 | $CH_3$ | H | OH | H | erfindungsgemäß |
| V1 | $CH_3$ | NH | 1 | 1 | $CH_3$ | $CH_3$ | H | OH | Vergleich entsprechend DE-A 38 20 699 |
| V2 | $CH_3$ | O | 0 | 1 | H | H | OH | H | Vergleich entsprechend EP-A- 0 212 440 |
| V3 | H | - | 0 | 0 | H | H | H | OH | Vergleich entsprechend DE-A 23 22 230 |

**Tabelle 2:**

| Polymerisat Nr | Monomer (Mol-%) | Monomer (Mol-%) | Monomer (Mol-%) | RSV-Wert[1)] | Bemerkungen |
|---|---|---|---|---|---|
| 1 | 1 (100) | - | - | 0,23 | erfindungsgemäß |
| 2 | 2 (100) | - | - | 0,22 | erfindungsgemäß |
| 3 | 3 (100) | - | - | 0,24 | erfindungsgemäß |
| 4 | 4 (100) | - | - | 0,22 | erfindungsgemäß |
| 5 | 2 (75) | Styrol (25) | - | 0,20 | erfindungsgemäß |
| V1 | V1 (100) | - | - | 0,26 | Vergleichsbeispiel |
| V2 | V1 (20) | V2 (55) | Styrol (25) | 0,22 | Vergleichsbeispiel |
| V3 | V2 (100) | | - | 0,24 | Vergleichsbeispiel |
| V4 | V2 (75) | Styrol (25) | - | 0,21 | Vergleichsbeispiel |
| V5 | V3 (100) | | - | 0,23 | Vergleichsbeispiel |
| V6 | V3 (50) | Styrol (50) | | 0,20 | Vergleichsbeispiel |

1) RSV = reduzierte spezifische Viskosität der Polymerisate in dl/g; bestimmt in Dimethylformamid

**Beispiel 1**

Eine in Salzsäure elektrolytisch aufgerauhte, in Schwefelsäure anodisierte und mit Polyvinylphosphonsäure hydrophilierte Aluminiumplatte wird mit folgender Lösung schleuderbeschichtet:

7,0 Gt (Gewichtsteile) Bindemittel (vgl. Tabelle 3),

1,5 Gt eines Veresterungsproduktes aus 3 Mol 1,2-Naphthochinon-(2)-diazid-4-sulfinylchlorid und 1

| | |
|---|---|
| | Mol 2,3,4-Trihydroxybenzophenon, |
| 0,2 Gt | 1,2-Naphthochinon-(2)-diazid-4-sulfonylchlorid, |
| 0,08 Gt | Victoriareinblau (C.I. 44 045), |
| 100 Gt | eines Lösungsmittelgemisches aus Tetrahydrofuran und Propylenglykolmonomethylether (55:45). |

Nach 2-minütigem Trocknen bei 100 °C resultiert eine Schichtdicke von 2 µm.

Prüfung der Lichtempfindlichkeit:

Die Druckplatten werden unter einer 5-kW-Metallhalogenidlampe im Abstand von 110 cm durch einen Halbtonstufenkeil mit 13 Dichtestufen von je 0,15 (Belichtungskeil "BK 01" der Hoechst AG) 60 Sekunden (s) lang belichtet und 60 Sekunden lang in einem der folgenden Entwickler entwickelt:

Entwickler A

| | |
|---|---|
| 8,5 Gt | $Na_2SiO_3$ x 9 $H_2O$, |
| 0,8 Gt | NaOH und |
| 1,5 Gt | $Na_2B_4O_7$ x 10 $H_2O$ in |
| 89,2 Gt | $H_2O$. |

Entwickler B:

| | |
|---|---|
| 5,3 Gt | Natriummetasilikat x 9 $H_2O$, |
| 3,4 Gt | Trinatriumphospaht x 12 $H_2O$, |
| 0,3 | Natriumhydrogenphospaht (wasserfrei), |
| 91,0 Gt | Wasser. |

Die Lichtempfindlichkeit wird anhand der Stufe 3 des Halbtonstufenkeils beurteilt: offen = bereits frei von Kopierschicht, nicht offen = Kopierschichtreste noch vorhanden.

Prüfung des Aufentwicklungsverhaltens:

Die belichteten Platten werden 15 Sekunden lang entwickelt und dann mit handelsüblicher schwarzer Offsetfarbe eingefärbt. Beurteilt wird das Auftreten von Ton in den bildfreien Partien.

Prüfung des thermischen Vernetzungsverhaltens:

Die Platten werden mit einer handelsüblichen Einbrenngummierung (zum Beispiel RC 99 der HOECHST AG) überwischt und 5 Minuten bei 230 °C in einem Lacktrockenschrank eingebrannt. Mit Dimethylformamid wird die Chemikalienresistenz der eingebrannten Platten geprüft.

**Tabelle 3:**

| Beispiel Nr. | Polymerisat Nr. | Halbtonstufe 3 | Entwickler | Aufentwicklung | Chemikalienresistenz nach Einbrennen |
|---|---|---|---|---|---|
| 1 - 1 | 1 | offen | B | tonfrei | + |
| 1 - 2 | 2 | offen | B | tonfrei | + |
| 1 - 3 | 3 | offen | B | tonfrei | + |
| 1 - 4 | 4 | offen | B | tonfrei | + |
| 1 - 5 | 5 | offen | A | tonfrei | + |
| 1 - 6 | V1 | nicht offen | B | Ton | + |
| 1 - 7 | V2 | offen | A | tonfrei | - |
| 1 - 8 | V3 | offen | B | tonfrei | - |
| 1 - 9 | V4 | offen | A | tonfrei | - |
| 1 - 10 | V5 | offen | B | tonfrei | - |
| 1 - 11 | V6 | offen | A | tonfrei | - |
| 1 - 12 | m-Kresol-Formaldehyd-Novolak (Vergleich) | offen | A | tonfrei | + |

Von einer Reihe dieser Platten wurden im nicht thermisch gehärteten Zustand Druckversuche in einer Bogenoffsetmaschine durchgeführt. Tabelle 4 gibt die Ergebnisse wieder.

**Tabelle 4:**

| Beispiel Nr. | Polymer | Druck-auflage |
|---|---|---|
| 1 - 2 | 2 | 150.000 |
| 1 - 5 | 5 | 160.000 |
| 1 - 7 (Vergleich) | V2 | 160.000 |
| 1 - 9 (Vergleich) | V4 | 150.000 |
| 1 - 11 (Vergleich) | V6 | 140.000 |
| 1 - 12 (Vergleich) | m-Kresol Formaldehyd-Novolak | 90.000 |

Die Ergebnisse zeigen, daß die Druckplattenkopierschichten mit dem erfindungsgemäßen Gemisch eine höhere Druckauflage als herkömmliche Positivkopierschichten mit Novolaken als Bindemittel ergeben, daß sie durch thermische Nachhärtung resistent gegen aggressive Chemikalien werden, und daß sie auf die gute Lichtempfindlichkeit und Aufentwicklung keine nachteiligen Auswirkungen haben.

**Beispiel 2**

Zur Herstellung eines Positivtrockenresists werden Beschichtungslösungen hergestellt aus:

40,0 Gt Bindemittel (vgl. Tabeel 5),
10,0 Gt einer Verbindung mit säuresplatbaren C-O-C-Einheiten (Tabelle 5),
0,5 Gt eines photochemischen Säurebildners (Tabelle 5),
6,0 Gt Polyethylacrylat,
0,01 Gt Kristallviolett-Base (C.I. 42 555:1),
100 Gt Butanon.

Die Lösungen werden jeweils auf 26 µm dicke, biaxial gestreckte und thermofixierte Polyethylenterephthalatfolien aufgeschleudert und anschließend 10 Minuten lang bei 100 °C im Umlufttrockenschrank nachgetrocknet. Die Umdrehungszahl der Schleuder wird so reguliert, daß sich eine Schichtdicke von 25 µm ergibt. Zum Schutz gegen Staub und Verkratzungen wird darauf noch eine Polyethylenfolie als Deckfolie kaschiert.

Zur Herstellung von Leiterplatten werden die Trockenresists nach Abziehen der Deckfolie in einem handelsüblichen Laminator auf einen gereinigten, vorgewärmten Träger, der aus einem Isoliermaterial mit ein- oder beidseitiger, 35 µm dicker Kupferauflage besteht, laminiert. Nach Abziehen der Trägerfolie und eventuellem Nachtrocknen wird unter einer Vorlage mit einer 5-kW-Metallhalogenidlampe in 110 cm Abstand 30 Sekunden lang belichtet und nach einer Wartezeit von 15 Minuten in 1 %iger Natronlauge 90 Sekunden lang entwickelt.

Die auf diese Weise entstandenen Resistschablonen weisen eine hervorragende Galvanoresistenz auf, insbesondere bei dem galvanischen Aufbau von Kupfer und Pb/Sn-Legierungen.

Derartige Platten lassen sich anschließend erneut belichten und entwickeln. Mit dieser Arbeitsweise lassen sich in einem ersten Schritt Lötaugen aus Pb/Sn an den Bohrlöchern aufgalvanisieren, in einem zweiten Belichtungs- und Entwicklungsschritt läßt sich dann das Leiterbahnbild auf die noch bestehende Resistschicht übertragen. Nach dem Ätzen des freigelegten Kupfers mit ammoniakalischer Cu(II-)chlorid-Lösung erhält man eine Leiterplatte in Kupfertechnik, d.h., die Pb/Sn-Legierung wird nur dort aufgebaut, wo sie beim nachfolgenden Lötprozeß benötigt wird.

Die Ergebnisse sind in Tabelle 5 aufgezeigt. Folgende Verbindungen mit säurespaltbaren C-O-C-Einheiten wurden eingesetzt:

Nr. 1: polymerer Orthoester, hergestellt durch Kondensation von Orthoameisensäuretrimethylester mit 4-Oxa-6,6-bis-hydroxymethyloctan-1-ol,
Nr. 2: Polyacetal, hergestellt aus Triethylenglykol und 2-Ethylbutyraldehyd.

Folgende photochemischen Säurebildner wurden verwendet:

Nr. 1: 2-(4-Ethoxy-naphth-1-yl)-4,6-bis-trichlormethyl-s-triazin,
Nr. 2: 2-(4-Styrylphenyl)-4,6-bis-trichlormethyl-s-triazin.

**Tabelle 5:**

| Beispiel Nr. | Polymerisat Nr. | säurespaltbare Verbndg. Nr. | photochem. Säurebildner Nr. | Belichtungszeit (s) |
|---|---|---|---|---|
| 2 - 1 | 5 | 1 | 1 | 25 |
| 2 - 2 | 5 | 1 | 2 | 23 |
| 2 - 3 | 5 | 2 | 1 | 27 |
| 2 - 4 | 5 | 2 | 2 | 25 |

**Beipiel 3:**

Zur Herstellung hochauflösender Positiv-Flüssigresists werden folgende Beschichtungslösungen hergestellt:

26 Gt Bindemittel (vgl. Tabelle 6),
4 Gt eines Veresterungsproduktes aus 3 Mol 1,2-Naphthochinon-(2)-diazid-4-sulfonylchlorid und 1 Mol 2,3,4-Trihydroxybenzophenon,
80 Gt Propylenglykolmonomethyletheracetat.

Nach Filtration durch ein Filter mit Porendurchmesser von 0,2 µm (Millipore) werden die Photoresistlösungen auf käufliche, wie üblich polierte und durch Oxidation mit einer 0,2 µm dicken $SiO_2$-Schicht versehene Siliciumscheiben geschleudert. Bei einer Umdrehungszahl von 8000/min werden Schichtdicken zwischen 0,9 und 1 µm erhalten.

Die so beschichteten Scheiben werden 30 Minuten lang bei 90 °C getrocknet. Nach dem Abkühlen und Konditionieren auf ein definiertes Raumklima von 23 °C und 40 bis 50 % relativer Feuchte werden die Wafer in einem Kontaktbelichtungsgerät mit einer Intensität von 4,5 $mW/cm^2$ bei 365 nm unter einer handelüblichen Chrommaske belichtet und 60 Sekunden lang in einer 2,86 %igen Tetramethylammoniumhydroxidlösung entwickelt. In allen Fällen ist eine Wiedergabe von 1-µm -Linien und -Spalten möglich.

Nach einer Wärmebehandlung von 30 Minuten bei 150 °C werden die Flanken der Strukturen beurteilt. In Tabelle 6 sind die Ergebnisse dargelegt.

**Tabelle 6:**

| Beispiel Nr. | Polymerisat Nr. | Belichtungszeit (s) | Flankenstruktur nach Wärmebehandlung |
|---|---|---|---|
| 3 - 1 | 1 | 20 | wenig verändert |
| 3 - 2 | 2 | 20 | wenig verändert |
| 3 - 3 | 3 | 20 | leicht gerundet |
| 3 - 4 | 4 | 20 | wenig verändert |
| 3 - 5 | 5 | 25 | wenig verändert |
| 3 - 6 | m-Kresol-Formaldehyd-Novolak (Vergleich) | 25 | sehr starke Neigung der Flanken |

**Patentansprüche**

1. Positiv arbeitendes strahlungsempfindliches Gemisch, das als wesentliche Bestandteile ein in Wasser unlösliches, in wäßrig-alkalischen Lösungen lösliches polymeres Bindemittel und ein 1,2-Chinondiazid und/oder eine Kombination aus einer unter Einwirkung von aktinischer Strahlung starke Säure bildenden Verbindung und einer Verbindung mit mindestens einer spaltbaren C-O-C- Bindung enthält, dadurch gekennzeichnet, daß das Gemisch als Bindemittel ein Polymeres mit Einheiten der allgemeinen Formel I

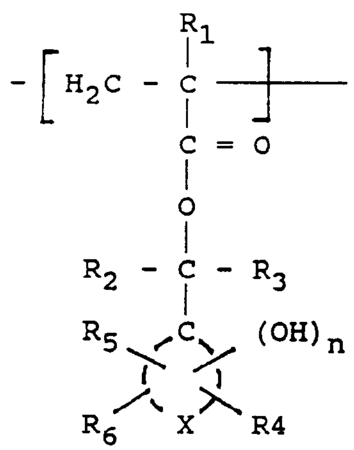

I

enthält, worin

| | |
|---|---|
| $R_1$ | ein Wasserstoff- oder Halogenatom, eine Cyanid- oder eine Alkylgruppe, |
| $R_2$, $R_3$ | gleich oder verschieden sind und Wasserstoff, Alkyl- oder Arylgruppen, |
| $R_4$, $R_5$ und $R_6$ | gleich oder verschieden sind und Wasserstoff-oder Halogenatome, Alkyl-, Alkoxy- oder Arylgruppen, |
| X | die zur Vervollständigung eines ein- oder mehrkernigen carbocyclischen aromatischen Ringsytems erforderlichen Atome und |
| n | 1, 2 oder 3 |

bedeuten.

2. Gemisch nach Anspruch 1, dadurch gekennzeichnet, daß

| | |
|---|---|
| $R_1$ | ein Wasserstoff- oder Halogenatom, eine Cyanid- oder eine $C_1$ - $C_6$ Alkylgruppe, |
| $R_2$, $R_3$ | gleich oder verschieden sind und Wasserstoff oder $C_1$ - $C_4$ Alkylgruppen |
| $R_4$, $R_5$ und $R_6$ | gleich oder verschieden sind und Wasserstoff, $C_1$ - $C_4$ Alkylgruppen oder Halogen, |
| X | die zur Vervollständigung eines Benzol- oder Napthalinrings erforderlichen Kohlenstoffatome und |
| n | 1 |

bedeuten.

3. Gemisch nach Anspruch 1 oder 2, dadurch gekennzeichnet, daß

| | |
|---|---|
| $R_1$ | Wasserstoff oder die Methylgruppe, |
| $R_2$, $R_3$ und $R_4$ | Wasserstoff, |
| $R_5$ | Wasserstoff, eine $C_1$ - $C_4$ Alkylgruppe oder Halogen, |
| $R_6$ | Wasserstoff, eine $C_1$ - $C_4$ Alkylgruppe, eine Arylgruppe oder Halogen, |
| X | die zur Vervollständigung eines Benzol- oder Napthalinrings erfor- |

| | |
|---|---|
| | derlichen Kohlenstoffatome und |
| n | 1 |

bedeuten.

**4.** Gemisch nach Ansprüchen 1 bis 3, dadurch gekennzeichnet, daß das Gemisch als Bindemittel ein Polymeres enthält mit Einheiten der allgemeinen Formel II

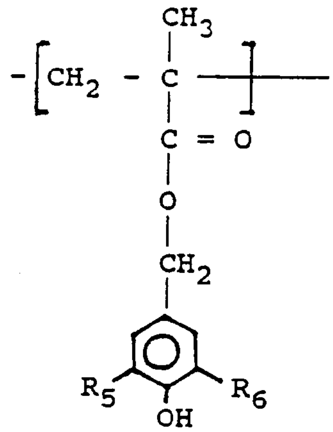

II

worin

| | |
|---|---|
| $R_5$ und $R_6$ | gleich oder verschieden sind und Wasserstoff, $C_1$ - $C_4$ Alkyl oder Halogen |

bedeuten.

**5.** Gemisch nach Ansprüchen 1 bis 3, dadurch gekennzeichnet, daß das Gemisch als Bindemittel ein polymeres enthält mit Einheiten der allgemeinen Formel III

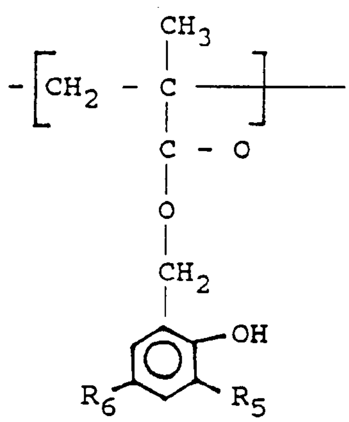

III

worin

| | |
|---|---|
| $R_5$ | $C_1$ - $C_4$ Alkyl oder Halogen und |
| $R_6$ | $C_1$ - $C_4$ Alkyl, Halogen oder ein gegebenenfalls durch Alkyl, Alkoxy oder Halogen substituiertes Aryl |

bedeuten.

**6.** Gemisch nach Anspruch 1, dadurch gekennzeichnet, daß das polymere Bindemittel ferner eine oder mehrere verschiedene wiederkehrende Einheiten der allgemeinen Formel IV

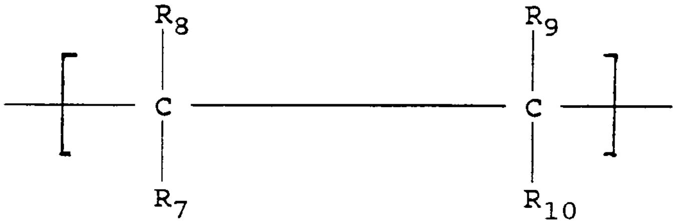

IV

enthält worin

$R_7$ Wasserstoff,

$R_8$ Wasserstoff oder eine Carboxylgruppe, die mit $R_9$, wenn letzteres eine Carboxylgruppe ist, zu einem Säureanhydrid oder einem gegebenenfalls durch Alkyl substituierten Imid verbunden sein kann,

$R_9$ eine Alkyl-, Alkoxy-, Alkoxycarbonyl-, Acyl-, Acyloxy-, Aryl-, Aryloxycarbonyl-, Formyl-, Cyanid-, Carboxyl-, Hydroxyl- oder Aminocarbonylgruppe und

$R_{10}$ Wasserstoff, Halogen oder eine Alkylgruppe

bedeuten.

**7.** Gemisch nach Anspruch 6, dadurch gekennzeichnet, daß

$R_7$ und $R_8$ Wasserstoff,

$R_9$ eine $C_1$ - $C_4$ Alkylgruppe, eine $C_1$ - $C_8$ Alkoxygruppe, eine Alkoxycarbonylgruppe mit 2 - 13 Kohlenstoffatomen, eine Acyloxygruppe mit 2 - 18 Kohlenstoffatomen, eine Arylgruppe mit 6 - 10 Kohlenstoffatomen oder eine Aryloxycarbonylgruppe mit 7 - 11 Kohlenstoffatomen, wobei die Arylgruppen durch Hydroxylgruppen substituiert sein können, und

$R_{10}$ Wasserstoff oder die Methylgruppe

bedeuten.

**8.** Strahlungsempfindliches Aufzeichnungsmaterial aus einem Schichtträger und einer strahlungsempfindlichen Schicht, die ein Gemisch nach Ansprüchen 1 bis 7 enthält.

## Claims

**1.** A positive-working radiation-sensitive mixture that contains, as essential constituents, a water-insoluble polymeric binder which is soluble in aqueous alkaline solutions and a 1,2-quinone diazide and/or a combination of a compound which forms strong acid on exposure to actinic radiation and a compound containing at least one cleavable C-O-C bond, which mixture contains, as binder, a polymer containing units of the formula I

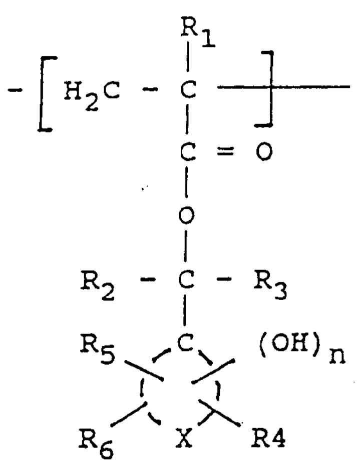

I

in which

| | |
|---|---|
| $R_1$ | is a hydrogen or halogen atom, or a cyanide or an alkyl group, |
| $R_2$, $R_3$ | are identical or different and are hydrogen, or alkyl or aryl groups, |
| $R_4$, $R_5$ and $R_6$ | are identical or different and are hydrogen or halogen atoms, or alkyl, alkoxy or aryl groups, |
| X | is the atoms necessary to complete a monocyclic or polycyclic carbocyclic aromatic ring system, and |
| n | is 1, 2 or 3. |

**2.** A mixture as claimed in claim 1, wherein

| | |
|---|---|
| $R_1$ | is a hydrogen or halogen atom, or a cyanide or a $(C_1-C_6)$alkyl group, |
| $R_2$, $R_3$ | are identical or different and are hydrogen or $(C_1-C_4)$alkyl groups, |
| $R_4$, $R_5$ and $R_6$ | are identical or different and are hydrogen, $(C_1-C_4)$alkyl groups or halogen, |
| X | is the carbon atoms necessary to complete a benzene or naphthalene ring, and |
| n | is 1. |

**3.** A mixture as claimed in claim 1 or 2, wherein

| | |
|---|---|
| $R_1$ | is hydrogen or the methyl group, |
| $R_2$, $R_3$ and $R_4$ | are hydrogen, |
| $R_5$ | is hydrogen, a $(C_1-C_4)$alkyl group or halogen, |
| $R_6$ | is hydrogen, a $(C_1-C_4)$alkyl group, an aryl group or halogen, |
| X | is the carbon atoms necessary to complete a benzene or naphthalene ring, and |
| n | is 1. |

**4.** A mixture as claimed in claims 1 to 3, which contains, as binder, a polymer containing units of the formula II

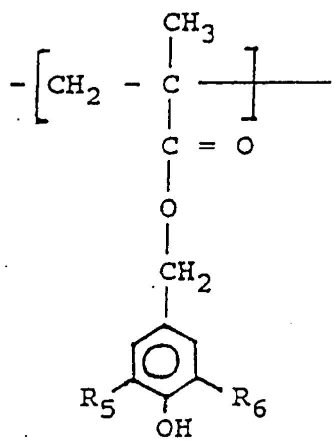

II

in which

$R_5$ and $R_6$ are identical or different and are hydrogen, $(C_1-C_4)$alkyl or halogen.

**5.** A mixture as claimed in claims 1 to 3, which contains, as binder, a polymer containing units of the formula III

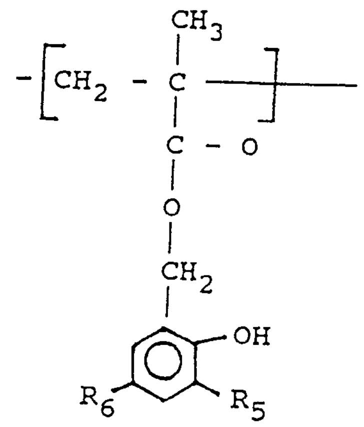

III

in which

$R_5$ is ($C_1$-$C_4$)alkyl or halogen, and

$R_6$ is ($C_1$-$C_4$)alkyl, halogen or aryl optionally substituted by alkyl, alkoxy or halogen.

6. A mixture as claimed in claim 1, wherein the polymeric binder also contains one or more different recurring units of the formula IV

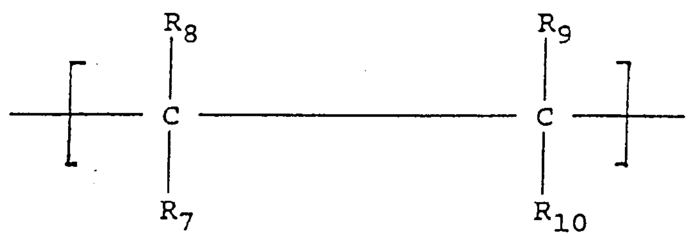

IV

in which

$R_7$ is hydrogen,

$R_8$ is hydrogen or a carboxyl group which can be linked to $R_9$, if the latter is a carboxyl group, to form an acid anhydride or an imide optionally substituted by alkyl,

$R_9$ is an alkyl, alkoxy, alkoxycarbonyl, acyl, acyloxy, aryl, aryloxycarbonyl, formyl, cyanide, carboxyl, hydroxyl or aminocarbonyl group, and

$R_{10}$ is hydrogen, halogen or an alkyl group.

7. A mixture as claimed in claim 6, wherein

$R_7$ and $R_8$ are hydrogen,

$R_9$ is a ($C_1$-$C_4$)alkyl group, a ($C_1$-$C_8$)alkoxy group, an alkoxycarbonyl group containing 2 - 13 carbon atoms, an acyloxy group containing 2 - 18 carbon atoms, an aryl group containing 6 - 10 carbon atoms or an aryloxycarbonyl group containing 7 - 11 carbon atoms, it being possible for the aryl groups to be substituted by hydroxyl groups, and

$R_{10}$ is hydrogen or the methyl group.

8. A radiation-sensitive recording material comprising a layer support and a radiation-sensitive layer which contains a mixture as claimed in claims 1 to 7.

## Revendications

1. Composition sensible aux radiations, travaillant en positif, qui contient en tant que composants essentiels un liant polymère insoluble dans l'eau, soluble dans des solutions aqueuses-alcalines, et un 1,2-quinonediazide et/ou une association d'un composé formant un acide fort, sous l'effet d'un rayonnement actinique, et d'un composé comportant au moins une liaison C-O-C sécable, caractérisée en ce que la composition contient en tant que liant un polymère comportant des motifs de formule générale I

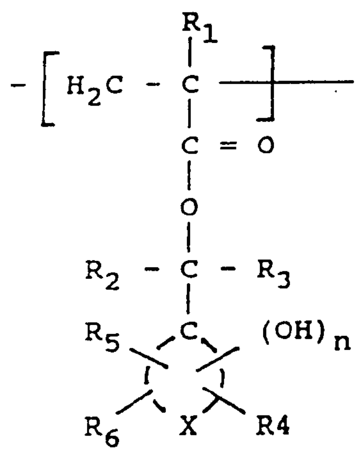

I

dans laquelle

| | |
|---|---|
| $R_1$ | est un atome d'hydrogène ou d'halogène, ou un groupe cyano ou alkyle, |
| $R_2$, $R_3$, | sont identiques ou différents et représentent un atome d'hydrogène ou un groupe alkyle ou aryle, |
| $R_4$, $R_5$ et $R_6$ | sont identiques ou différents et représentent un atome d'hydrogène ou d'halogène, ou un groupe alkyle, alcoxy ou aryle, |
| X | représente les atomes requis pour compléter un système cyclique carbocyclique aromatique mono- ou polynucléaire, et |
| n | est 1, 2 ou 3. |

**2.** Composition selon la revendication 1, caractérisée en ce que

| | |
|---|---|
| $R_1$ | est un atome d'hydrogène ou d'halogène, ou un groupe cyano ou alkyle en $C_1$-$C_6$, |
| $R_2$, $R_3$ | sont identiques ou différents et représentent un atome d'hydrogène ou un groupe alkyle en $C_1$-$C_4$, |
| $R_4$, $R_5$ et $R_6$ | sont identiques ou différents et représentent un atome d'hydrogène ou d'halogène, ou un groupe alkyle en $C_1$-$C_4$, |
| X | représente les atomes de carbone requis pour compléter un cycle benzénique ou naphtalénique et |
| n | est 1. |

**3.** Composition selon la revendication 1 ou 2, caractérisée en ce que

| | |
|---|---|
| $R_1$ | est un atome d'hydrogène ou le groupe méthyle, |
| $R_2$, $R_3$ et $R_4$ | représentent des atomes d'hydrogène, |
| $R_5$ | représente un atome d'hydrogène ou d'halogène ou un groupe alkyle en $C_1$-$C_4$, |
| $R_6$ | représente un atome d'hydrogène ou d'halogène ou un groupe alkyle en $C_1$-$C_4$ ou aryle, |
| X | représente les atomes de carbone requis pour compléter un cycle benzénique ou naphtalénique et |
| n | est 1. |

**4.** Composition selon les revendications 1 à 3, caractérisée en ce que la composition contient en tant que liant un polymère à motifs de formule générale II

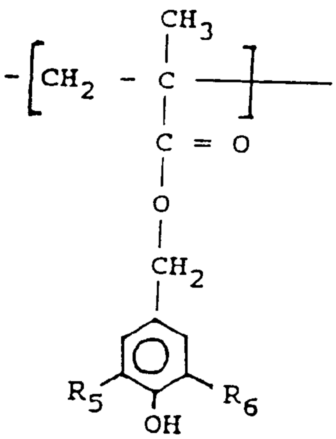

II

dans laquelle

$R_5$ et $R_6$ sont identiques ou différents et représentent un atome d'hydrogène ou d'halogène ou un groupe alkyle en $C_1$-$C_4$.

**5.** Composition selon les revendication 1 à 3, caractérisée en ce que la composition contient en tant que liant un polymère à motifs de formule générale III

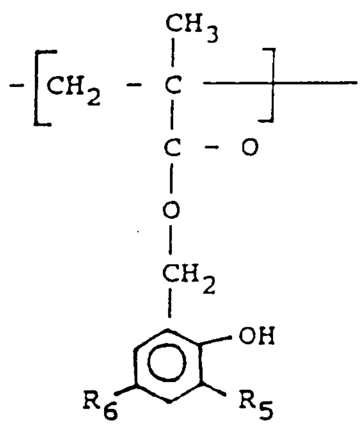

III

dans laquelle

$R_5$ représente un atome d'halogène ou un groupe alkyle en $C_1$-$C_4$, et

$R_6$ représente un groupe alkyle en $C_1$-$C_4$ ou un atome d'halogène, ou un groupe aryle éventuellement substitué par un atome d'halogène ou par un groupe alkyle ou alcoxy,

**6.** Composition selon la revendication 1, caractérisée en ce que le liant polymère contient en outre un ou plusieurs motifs répétitifs différents de formule générale IV

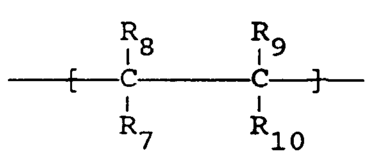

IV

dans laquelle

$R_7$ représente un atome d'hydrogène,

$R_8$ représente un atome d'hydrogène ou un groupe carboxy qui peut être lié à $R_9$ lorsque ce dernier est un groupe carboxy, pour former un anhydride d'acide ou un imide éventuellement substitué par un groupe alkyle,

$R_9$ représente un groupe alkyle, alcoxy, alcoxycarbonyle, acyle, acyloxy, aryle, aryloxycarbonyle,

formyle, cyano, carboxy, hydroxy ou aminocarbonyle, et

$R_{10}$ représente un atome d'hydrogène ou d'halogène ou un groupe alkyle.

**7.** Composition selon la revendication 6, caractérisée en ce que

$R_7$ et $R_8$ représentent un atome d'hydrogène,

$R_9$ représente un groupe alkyle en $C_1$-$C_4$, un groupe alcoxy en $C_1$-$C_8$, un groupe alcoxycarbonyle ayant de 2 à 13 atomes de carbone, un groupe acyloxy ayant de 2 à 18 atomes de carbone, un groupe aryle ayant de 6 à 10 atomes de carbone ou un groupe aryloxycarbonyle ayant de 7 à 11 atomes de carbone, les groupes aryle pouvant être substitués par des groupes hydroxy,

$R_{10}$ représente un atome d'hydrogène ou le groupe méthyle.

**8.** Matériau de reprographie sensible aux radiations, comportant un support de couche et une couche sensible aux radiations, qui contient une composition selon les revendications 1 à 7.